(19) Europäisches Patentamt
European Patent Office
Office européen des brevets

(11) **EP 1 890 165 B1**

(12) **FASCICULE DE BREVET EUROPEEN**

(45) Date de publication et mention
de la délivrance du brevet:
**21.03.2012 Bulletin 2012/12**

(21) Numéro de dépôt: **07354026.2**

(22) Date de dépôt: **27.04.2007**

(51) Int Cl.:
**G01R 31/02** $^{(2006.01)}$ **H02H 3/32** $^{(2006.01)}$

(54) **Procédé de détection directionnel d'un défaut à la terre et dispositif pour sa mise en oeuvre**

Verfahren zur Richtungserkennung eines Massefehlers und Vorrichtung zur Umsetzung dieses Verfahrens

Method of directional detection of a fault in the ground connection and device for implementing the same

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **23.06.2006 FR 0605668**

(43) Date de publication de la demande:
**20.02.2008 Bulletin 2008/08**

(73) Titulaire: **Schneider Electric Industries SAS 92500 Rueil-Malmaison (FR)**

(72) Inventeurs:
• **Gotzig, Bernhard,
Schneider Electric
38050 Grenoble Cedex 09 (FR)**
• **Bastard, Patrick,
Schneider Electric
38050 Grenoble Cedex 09 (FR)**

(74) Mandataire: **Tripodi, Paul et al
Schneider Electric Industries SAS
Service Propriété Industrielle
World Trade Center - E1
5 Place Robert Schuman
38050 Grenoble Cedex 9 (FR)**

(56) Documents cités:
EP-A- 0 999 633        WO-A-95/09467
WO-A-2004/079378

## Description

La présente invention concerne un procédé de détection directionnel de défaut terre aval, comprenant une étape consistant à fournir des signaux représentatifs des courants de phase, et une étape de traitement pour signaler une détection de défaut terre aval en fonction desdits signaux représentatifs des courants de phase, ainsi qu'un dispositif pour sa mise en oeuvre.

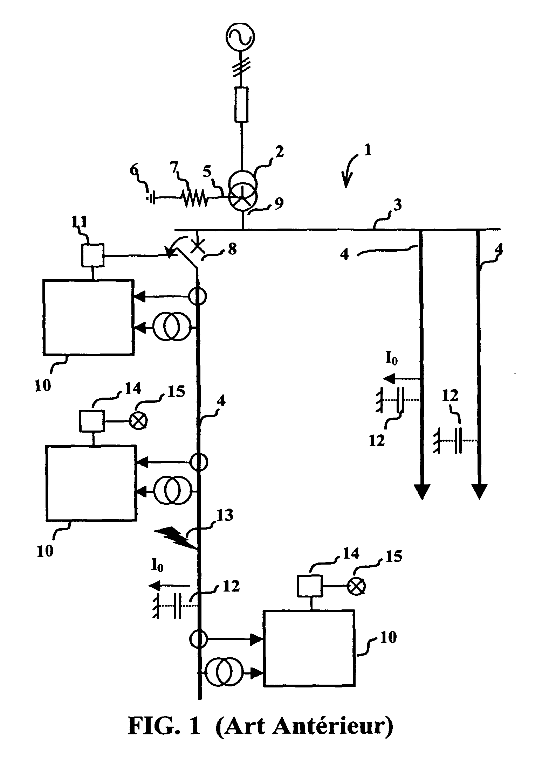

Les dispositifs de détection de défaut à la terre tels que les indicateurs de passage de défaut (IPD) ainsi que les relais de protection comportant de tels dispositifs sont utilisés notamment dans les réseaux de distribution électrique triphasés moyenne tension. Un schéma d'un réseau de distribution électrique est représenté sur la figure 1. Ce réseau 1 de distribution électrique comporte un transformateur 2 triphasé ayant un secondaire 9 connecté à une ligne principale 3 de distribution alimentant des lignes 4 de départ. Le secondaire du transformateur 2 comporte un conducteur commun de neutre 5 généralement connecté à la terre 6 par une impédance 7. Certaines lignes de départ 4 comportent un disjoncteur 8 pour protéger ladite ligne. Des dispositifs 10 de détection de défaut terre peuvent être disposés sur des lignes ou des tronçons du réseau. Par exemple, des dispositifs de détection 10 associés à des relais de protection 11 peuvent commander l'ouverture des contacts d'un disjoncteur 8 ou bien des dispositifs de détection 10 associés à un indicateur de passage de défaut 14 peuvent allumer un voyant lumineux 15.

Lorsque des lignes 4 de départ à protéger sont constituées de câbles enterrés, de fortes valeurs de capacité apparaissent entre les câbles et la terre. Ces capacités représentées par des condensateurs 12 sur la figure 1 font circuler d'importants courants homopolaires Io sur des lignes de départ sans défaut terre ou sur le départ en défaut en aval du défaut lorsqu'un défaut 13 est présent.

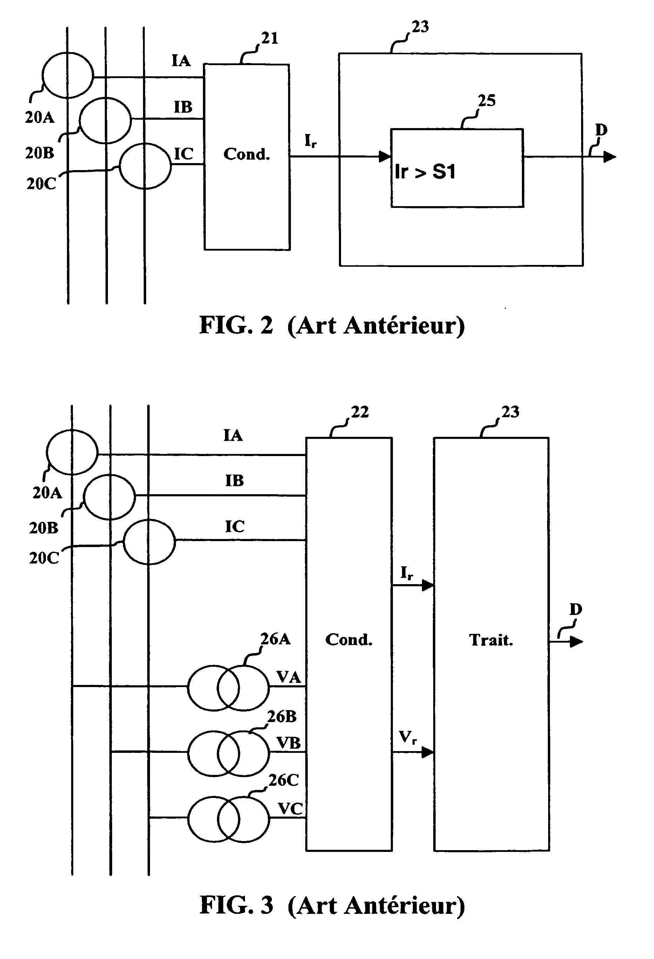

La figure 2 représente un schéma d'un dispositif connu de détection de défaut terre qui utilise des signaux de courant IA, IB, IC fournis par des capteurs de courants 20A, 20B, 20C. Généralement, le dispositif comporte un circuit de conditionnement 21 pour fournir un signal Ir représentatif d'un courant résiduel à un circuit de traitement 23. Le circuit de traitement comporte un module de comparaison 25 pour traiter le signal représentatif d'un courant résiduel et pour comparer ledit signal Ir traité à un seuil SI. Si le seuil S1 est dépassé, un signal D de détection est fourni pour signaler la détection d'un défaut terre.

Un tel dispositif ne peut pas distinguer un défaut terre en aval, d'un défaut terre en amont, en particulier avec des lignes enterrées.

Pour protéger des lignes de départ fortement capacitives, il existe des dispositifs de détection comportant, en plus des capteurs de courant, des transformateurs de tension pour permettre une détection directionnelle de terre. Un schéma bloc d'un tel dispositif est représenté sur la figure 3, Ainsi, des transformateurs de tension 26A, 26B et 26C fournissent des signaux de tension VA, VB et VC au circuit de conditionnement 22 pour déterminer un signal représentatif d'une tension résiduelle Vr. Le circuit de traitement 23 utilise le signal Ir pour détecter la présence d'un défaut terre et les signaux Ir et Vr pour détecter la direction d'un défaut en aval ou en amont.

Les dispositifs utilisant des transformateurs sont très volumineux et coûteux. De plus, ils ne sont pas toujours adaptés pour être disposés sur des lignes déjà installées. Parfois, il est même impossible de réaliser une mesure de la tension sans mettre en oeuvre des moyens très onéreux.

Lors d'un défaut à la terre dans un réseau moyenne tension, l'ensemble des détecteurs de défaut mesurent un courant dit résiduel correspondant à la somme des trois courants de phase, que ces appareils soient situés en amont ou en aval du défaut à la terre.

Dans le cas d'un réseau dont le neutre est mis à la terre par une bobine de compensation (réseau à neutre compensé), la valeur efficace du courant résiduel n'est pas suffisante pour décider si le défaut se situe en aval ou en amont du détecteur. Les dispositif connus utilisent alors la tension par rapport au courant résiduel pour déterminer la direction du défaut.

On connaît le document WO 2004/079378 décrivant un procédé de détection de défauts à 1a terre dans des réseaux de distribution électriques triphasés.

Le document EP 1 475 874 décrit un procédé de détection directionnel d'un défaut à la terre ainsi qu'un dispositif pour la mise en oeuvre de ce procédé qui permet d'éviter cette mesure de la tension. Dans ce dispositif, les moyens de traitement signalent un défaut terre aval si une valeur dudit signal représentatif de courant résiduel dépasse un premier seuil prédéterminé, et si un rapport entre une valeur représentative de l'amplitude du courant inverse et une valeur représentative d'un signal de courant résiduel dépasse au moins un second seuil prédéterminé ou bien est compris entre deux seuils.

La présente invention a pour objet un autre procédé et un autre dispositif réalisant la détection directionnel d'un défaut à la terre sans mesure de tension.

A cet effet, la présente invention a pour objet un procédé de détection directionnel d'un défaut terre aval, comprenant une étape consistant à fournir des signaux représentatifs des courants de phase, et une étape de traitement pour signaler une détection de défaut terre aval en fonction desdits signaux représentatifs des courants de phase, ce procédé étant caractérisé en ce que ladite étape de traitement comporte une étape de calcul du courant résiduel; une étape consistant à fournir un signal représentatif du courant résiduel, une étape de comparaison consistant à comparer la forme du courant résiduel avec la forme des courants de phases et une étape d'interprétation de cette comparaison permettant de déduire si le défaut est un défaut situé en aval ou non de l'appareil de détection du défaut.

Selon une réalisation particulière de l'invention, si la forme du courant résiduel ressemble fortement à la forme de l'un des courants de phase, on en déduit que le défaut est un défaut aval, et si la forme du courant résiduel ne ressemble pas fortement à la forme de l'un des courants de phase, mais ressemble seulement légèrement à deux courants de phase, on en déduit que le défaut n'est pas un défaut situé en aval de l'appareil de détection du défaut.

Selon une réalisation particulière, ce procédé est mis en oeuvre dans un réseau triphasé.

Selon une caractéristique particulière, ladite étape consistant à fournir des signaux représentatifs des courants de phase comporte une étape d'échantillonnage du courant.

La présente invention a encore pour objet un dispositif de détection directionnel d'un défaut terre aval pour la mise en oeuvre d'un procédé comportant les caractéristiques précédemment mentionnées prises seules ou en combinaison.

Ce dispositif comporte : -des moyens pour recevoir des signaux de courant et fournir des signaux représentatifs des courants de phase,

- des moyens de traitement de signal connectés aux premiers moyens précités pour recevoir lesdits signaux représentatifs des courants de phase et pour fournir un signal de détection de défaut terre en fonction desdits signaux représentatifs des courants de phase, ce dispositif étant caractérisé en ce que ces moyens de traitement comportent :

- des moyens de calcul du courant résiduel, des moyens de comparaison consistant à comparer la forme de ce courant résiduel avec la forme des courants de phase, et des moyens d'interprétation de cette comparaison consistant à déduire de cette comparaison si le défaut est un défaut aval ou non de l'appareil de détection du défaut.

Selon une caractéristique particulière de l'invention, les moyens d'interprétation de cette comparaison comportent un réseau de neurones, les valeurs des signaux appliqués sur les entrées du réseau de neurones étant représentatives de la ressemblance entre la forme des courants de phase et la forme du courant résiduel.

Selon une autre caractéristique particulière, le réseau de neurones comporte trois couches de neurone, six entrées et une sortie de signal de déclenchement, les six entrées étant connectées à une première couche comportant six neurones, la sortie étant connectée à une troisième couche comportant un neurone, une seconde couche comportant trois neurones étant connectée à la première et à la troisième couche.

Selon une autre caractéristique, le dispositif comporte un filtre analogique relié en entrée aux lignes de phases et en sortie aux entrées d'un dispositif d'échantillonnage dont les sorties sont reliées électriquement aux entrées d'un dispositif de pré-traitement relié en sortie aux entrées d'un réseau de neurones.

Selon une autre caractéristique particulière, l'appareil de détection est un relais de protection destiné à donner un ordre de déclenchement à un disjoncteur.

Selon une autre caractéristique particulière, l'appareil de détection est un indicateur de passage de défaut destiné à donner une information sur le passage de défaut.

Mais d'autres avantages et caractéristiques de l'invention apparaîtront mieux dans la description détaillée qui suit et se réfère aux dessins annexés donnés uniquement à titre d'exemple et dans lesquels :

- La figure 1 représente un schéma d'un réseau électrique dans lequel des dispositifs de détection de défaut terre peuvent être utilisés,

- Les figures 2 et 3 représentent des schémas blocs de dispositifs de détection terre selon des modes de réalisation de l'état de la technique,

- La figure 4 représente un schéma bloc d'un dispositif de détection de défaut terre selon un mode particulier de réalisation de l'invention,

- Les figures 5 et 6 sont une représentation schématique du réseau de neurones du dispositif selon l'invention,

- La figure 7 est une représentation graphique illustrant le courant résiduel mesuré par l'ensemble des appareils de détection de défaut en fonction du temps, dans le cas d'un défaut situé en aval des appareils,

- Les figures 8, 9 et 10 sont des représentations graphiques illustrant le courant respectivement dans une première phase, dans une seconde phase et une troisième phase du circuit électrique, en fonction du temps, dans le cas d'un défaut situé en aval des appareils,

- La figure 11 est une représentation graphique illustrant le courant résiduel mesuré par l'ensemble des appareils de détection de défaut en fonction du temps, dans le cas d'un défaut situé en amont des appareils,

- Les figures 12, 13 et 14 sont des représentations graphiques illustrant le courant respectivement dans une première phase, dans une seconde phase et une troisième phase du circuit électrique, en fonction du temps, dans le cas d'un défaut situé en amont des appareils,

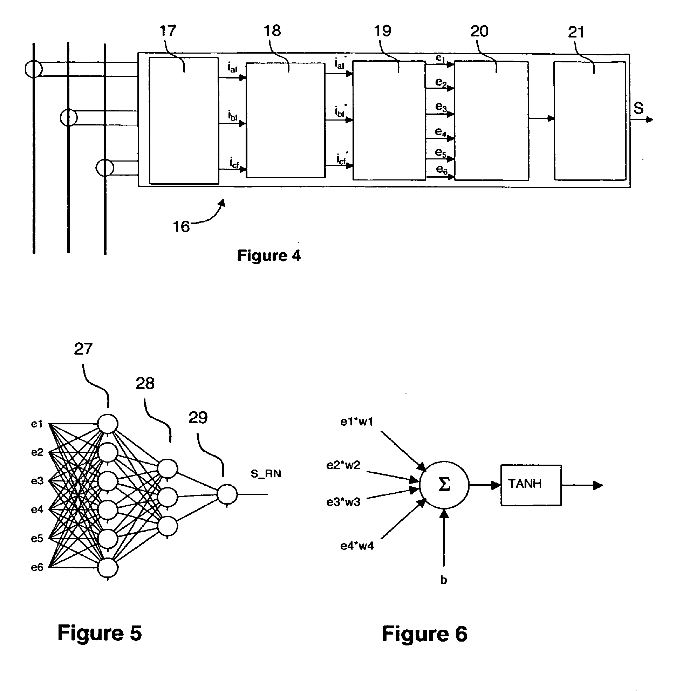

Sur la figure 4, le dispositif de détection directionnel de défaut à la terre 16 selon l'invention comporte un dispositif de filtrage analogique 17, un dispositif d'échantillonnage 18, un dispositif de pré-traitement 19, un réseau de neurones 20, et un dispositif de confirmation 21 du résultat. Le dispositif de filtrage 17 reçoit en entrée les trois courants de phase ia,ib,ic des phases a,b et c et délivre en sortie trois signaux de courant iaf,ibf,icf reliés respectivement aux trois entrées du dispositif d'échantillonnage 18, lequel délivre en sortie trois signaux de sortie iaf*,ibf* et icf* reliés respectivement aux trois entrées du dispositif de pré-traitement 19. Ce dispositif de pré-traitement 19 comporte six sorties reliées aux six entrées e1,e2,e3,e4,e5 et e6 d'un réseau de neurones 20 présentant une sortie SRN reliée en entrée à l'entrée du dispositif de confirmation 21 comportant une seule sortie S. Le réseau de neurones est tel que représenté sur les figures 5 et 6 et comporte trois couches 27,28,29 de neurone, six entrées e1,e2,e3,e4,e5 et e6 et une sortie de signal de déclenchement SRN, les six entrées e1,e2,e3,e4,e5 et e6 étant connectées à une première couche 27 comportant six neurones n, la sortie étant connectée à une troisième couche 29 comportant un neurone, une seconde couche 28 comportant trois neurones étant connectée à la première 27 et à la troisième couche 29.

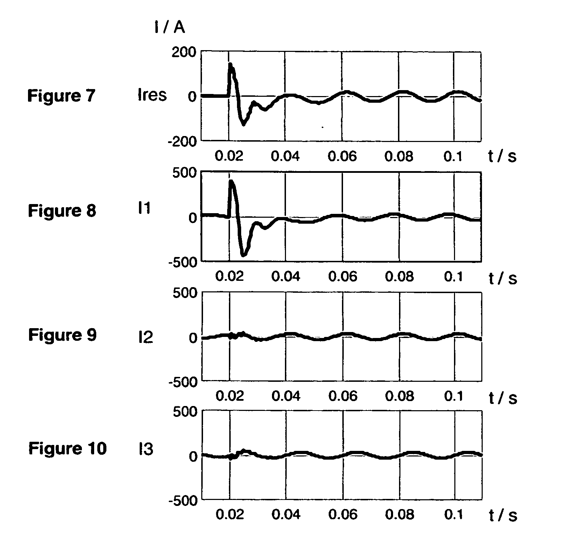

Sur les figures 7 à 10, sont représentés respectivement le courant résiduel et les trois courants de phase dans le cas d'un défaut à la terre situé en aval de l'appareil de protection électrique, à savoir un relais de protection ou un détecteur de défaut, les courants étant exprimés en A et les temps en secondes.

On observe que dans le cas d'un défaut en aval d'un appareil, le courant résiduel Ires ressemble fortement au courant I1 dans l'une des phases, en l'espèce la première phase.

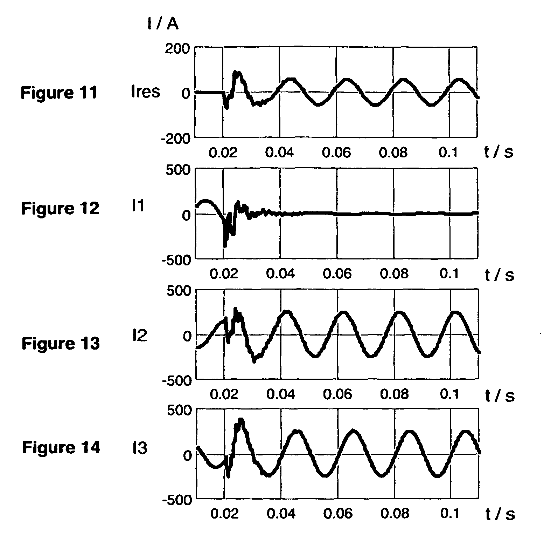

Sur les figures 11 à 14, sont représentés respectivement le courant résiduel Ires (fig. 11) et les trois courants de phase I1,I2,I3 (fig.12,fig.13 et fig.14) reçus par l'appareil dans le cas d'un défaut à la terre situé en amont de l'appareil de détection.

On observe que dans ce cas, le courant résiduel Ires (fig.11) ressemble un peu aux courants 12,13 de deux phases électriques, en l'espèce les phases 2 et 3 (fig.13,fig.14).

Le fonctionnement du dispositif selon le procédé de l'invention va être décrit ci-après en référence aux figures :

Tout d'abord, les courants de phase ia,ib,ic sont reçus par le dispositif de filtrage 17 qui envoie trois signaux de courant iaf,ibf et icf au dispositif d'échantillonnage18, lequel émet en sortie trois signaux de courant échantillonnés iaf*,ibf* et icf* qui sont reçus par le dispositif de pré-traitement 19.

Ce dispositif de pré-traitement 19 effectue les opérations suivantes :

Te étant la période d'échantillonnage, nTe étant l'instant courant, N étant le nombre de points dans une période et $I_{Rn}$ étant le courant actif efficace maximum circulant dans la résistance de neutre.

Une 1$^{ère}$ étape de calcul du courant résiduel :

$i_{rf}* = i_{af}* + i_{bf}* + i_{cf}*$' avec $i_{af}*$, $i_{bf}*$' et $i_{cf}*$ étant les valeurs des courants échantillonnés,

une 2$^{ème}$ étape de calcul des grandeurs intermédiaires suivantes :

$$\mathbf{mod\_}ia(nT_e) = |ia|^2_{\sin/\cos}$$

$$\mathbf{mod\_}ib(nT_e) = |ib|^2_{\sin/\cos}$$

$$\mathbf{mod\_}ic(nT_e) = |ic|^2_{\sin/\cos}$$

$$\text{mod\_}ir(nT_e) = |ir|^2_{\text{sin/cos}}$$

avec $|ia|^2_{\text{sin/cos}}$, $|ib|^2_{\text{sin/cos}}$, $|ic|^2_{\text{sin/cos}}$ et $|ir|^2_{\text{sin/cos}}$ les modules au carré des signaux calculés à partir d'un traitement de Fourier qui extrait la composante 50 Hz.

$$\text{mod\_}da(nT_e) = \frac{\left(|ia - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}db(nT_e) = \frac{\left(|ib - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}dc(nT_e) = \frac{\left(|ic - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))} ,$$

Une 3ème étape de calcul des entrées d'un réseau de neurones

$e_1$ = max(mod_$da$, mod_$db$, mod_$dc$)
$e_2$ = min(mod_$da$, mod_$db$, mod_$dc$)
$e_3$ = mod_$da$ + mod_$db$ + mod_$dc$-e1-e2

$$e_4 = \frac{\text{mod\_}ir}{2 * I_{Rn}^2}$$

$$e_5 = \left| \frac{1}{N} \sum_{k=n-N+1}^{n} \left( i_{rf}^{\bullet}(kT_e) \right) \right|$$

$$e_6 = \frac{\max\left(abs(\text{mod\_}ia - \text{mod\_}ib, \text{mod\_}ib - \text{mod\_}ic, \text{mod\_}ic - \text{mod\_}ia)\right)}{\text{mod\_}ia + \text{mod\_}ib + \text{mod\_}ic} .$$

Il s'agit là de la valeur maximale des trois valeurs absolues.
Le traitement comporte aussi une 4ème étape de calcul du réseau de neurones (RN) tel qu'illustré sur les figures 5 et 6. Comme le montre les fig.5 et 6, le réseau de neurones effectue une multitude d'opérations de type multiplications et additions et la fonction tanh (tangente hyperbolic). Les plages des coefficients du réseau de neurones seront avantageusement les suivantes :

Pour les 36 poids de la couche n°1 (w1,1 1 ... w1,66) entre : -3 et 7.
Pour les 18 poids de la couche n°2 (w2,11...w 2,36) entre -8 et 7.

Pour les 3 poids de la couche n°3 (w3,11...w3,3) entre -15 et 9.

Pour les facteurs de biais de la couche 1 (b1,1...b1,6) entre-4 et 4.
Pour les facteurs de biais de la couche 2 (b2,1...b2,3) entre -1 et 4.
Pour le facteur de biais b de la couche 3 (b3,1) entre 0 et 1.
Le dispositif selon l'invention fonctionne de la façon suivante :

Si la forme du courant résiduel Ires ressemble fortement à la forme de l'un des courants de phase, c'est à dire la phase 1 représentée sur la figure 8, alors le réseau de neurones en déduit qu'il s'agit d'un défaut situé en aval de l'appareil de détection.
Si la forme du courant résiduel (fig.11) ressemble légèrement à deux signaux de phase, en l'espèce les deux signaux de phases I2 et I3 représentés sur les figures 13 et 14, alors le réseau de neurones 20 en déduit qu'il ne s'agit pas d'un défaut situé en aval de l'appareil de détection.

Le dispositif de détection comporte en outre un dispositif de confirmation 21 du résultat fonctionnant de la façon suivante :

Le déclenchement de la fonction détection de défaut terre est activé si les 2 conditions suivantes sont remplies : S (t) > 0.5, S(t) étant la sortie du réseau de neurones à l'instant courant et IR > Ios c'est à dire la valeur maximale du courant résiduel étant supérieur à un seuil los réglable.
Ainsi, la distinction entre les défauts terre amont et les défauts terre aval est basée sur la reconnaissance de forme du courant résiduel dans un seul des courants de phase, pour les défauts «aval».
On a donc réalisé grâce à l'invention, un procédé ainsi qu'un dispositif pour sa mise en oeuvre, qui permette de détecter des défauts à la terre sur des réseaux de distribution d'énergie, le but étant de déterminer si un défaut à la terre se trouve en aval de l'appareil ou non, et ce sans mesure de la tension.

Le procédé selon l'invention permet de n'utiliser que la mesure des seuls courants de phase, alors que les procédés traditionnels, mesurent la tension pour déterminer la direction du défaut.
Ce dispositif est destiné à être associés avantageusement, mais pas exclusivement, à des relais de protection pour des réseaux électriques où à des indicateurs de passage de défaut pour des réseaux moyenne tension souterrains connectés en réseau.
On notera que la description a été basée sur une composante fondamentale de 50 Hz mais qu'une autre composante peut être utilisée telle une composante à 60Hz.

## Revendications

1. Procédé de détection directionnel d'un défaut terre aval, comprenant une étape consistant à fournir des signaux représentatifs des courants de phase, et une étape de traitement pour signaler une détection de défaut terre aval en fonction desdits signaux représentatifs des courants de phase, **caractérisé en ce que** ladite étape de traitement comporte une étape de calcul du courant résiduel, une étape consistant à fournir un signal représentatif du courant résiduel, une étape de comparaison consistant à comparer la forme du courant résiduel avec la forme des courants de phases et une étape d'interprétation de cette comparaison permettant de déduire si le défaut est un défaut situé en aval ou non de l'appareil de détection du défaut.

2. Procédé selon la revendication 1, **caractérisé en ce que** si la forme du courant résiduel ressemble fortement à la forme de l'un des courants de phase, on en déduit que le défaut est un défaut aval, et que si la forme du courant résiduel ne ressemble pas fortement à la forme de l'un des courants de phase, mais ressemble seulement légèrement à deux des courants de phase, on en déduit que le défaut n'est pas un défaut situé en aval de l'appareil de détection du défaut.

3. Procédé selon la revendication 1 ou 2, **caractérisé en ce qu'**il est mis en oeuvre dans un réseau triphasé et **en ce que** si la forme du courant résiduel ne ressemble pas fortement à la forme d'un seul courant de phase, mais ressemble seulement légèrement à deux courants de phase, on en déduit que le défaut n'est pas un défaut situé en aval de l'appareil de détection du défaut.

4. Procédé selon l'une quelconque des revendications 1 à 3, **caractérisé en ce que** ladite étape consistant à fournir des signaux représentatifs des courants de phase comporte une étape d'échantillonnage du courant.

**5.** Procédé selon la revendication 4, **caractérisé en ce que** l'étape de traitement comporte une étape de pré-traitement comportant les étapes suivantes :

Te étant la période d'échantillonnage, nTe étant l'instant courant, N étant le nombre de points dans une période et $I_{Rn}$ étant le courant actif efficace maximum dans une résistance de neutre.

Une 1 $^{ère}$ étape de calcul du courant résiduel :

$i_{rf}^* = i_{af}^* \; i_{bf}^* + i_{cf}^*$ avec $i_{af}^*$, $i_{bf}^{*'}$ et $i_{cf}^*$ étant les valeurs des courants échantillonnés,

une 2$^{ème}$ étape de calcul des grandeurs intermédiaires suivantes :

$$\mathrm{mod\_}ia(nT_e) = \left|ia\right|^2_{\sin/\cos}$$

$$\mathrm{mod\_}ib(nT_e) = \left|ib\right|^2_{\sin/\cos}$$

$$\mathrm{mod\_}ic(nT_e) = \left|ic\right|^2_{\sin/\cos}$$

$$\mathrm{mod\_}ir(nT_e) = \left|ir\right|^2_{\sin/\cos}$$

avec $\left|ia\right|^2_{\sin/\cos}$, $\left|ib\right|^2_{\sin/\cos}$, $\left|ic\right|^2_{\sin/\cos}$ et $\left|ir\right|^2_{\sin/\cos}$ les modules au carré des signaux calculés à partir d'un traitement de Fourier qui extrait la composante fondamentale,

$$\mathrm{mod\_}da(nT_e) = \frac{\left(\left|ia-ir\right|^2_{\sin/\cos} - \min(\mathrm{mod\_}ia(nT_e), \mathrm{mod\_}ib(nT_e), \mathrm{mod\_}ic(nT_e))\right)}{\max(\mathrm{mod\_}ia(nT_e), \mathrm{mod\_}ib(nT_e), \mathrm{mod\_}ic(nT_e))}$$

$$\mathrm{mod\_}db(nT_e) = \frac{\left(\left|ib-ir\right|^2_{\sin/\cos} - \min(\mathrm{mod\_}ia(nT_e), \mathrm{mod\_}ib(nT_e), \mathrm{mod\_}ic(nT_e))\right)}{\max(\mathrm{mod\_}ia(nT_e), \mathrm{mod\_}ib(nT_e), \mathrm{mod\_}ic(nT_e))}$$

$$\mathrm{mod\_}dc(nT_e) = \frac{\left(\left|ic-ir\right|^2_{\sin/\cos} - \min(\mathrm{mod\_}ia(nT_e), \mathrm{mod\_}ib(nT_e), \mathrm{mod\_}ic(nT_e))\right)}{\max(\mathrm{mod\_}ia(nT_e), \mathrm{mod\_}ib(nT_e), \mathrm{mod\_}ic(nT_e))} \; ,$$

Une 3$^{ème}$ étape de calcul des entrées d'un réseau de neurones.

$$e_1 = \max(\text{mod\_}da, \text{mod\_}db, \text{mod\_}dc)$$

$$e_2 = \min(\text{mod\_}da, \text{mod\_}db, \text{mod\_}dc)$$

$$e_3 = \text{mod\_}da + \text{mod\_}db + \text{mod\_}dc - e1 - e2$$

$$e_4 = \frac{\text{mod\_}ir}{2 * I_{Rn}^2}$$

$$e_5 = \left| \frac{1}{N} \sum_{k=n-N+1}^{n} \left( i_{rf}^{\bullet}(kT_e) \right) \right|$$

$$e_6 = \frac{\max\left(abs(\text{mod\_}ia - \text{mod\_}ib, \text{mod\_}ib - \text{mod\_}ic, \text{mod\_}ic - \text{mod\_}ia)\right)}{\text{mod\_}ia + \text{mod\_}ib + \text{mod\_}ic}.$$

**6.** Procédé de détection selon la revendication 5, **caractérisé en ce que** l'étape de traitement comporte également une 4ème étape de calcul du réseau de neurones (RN).

**7.** Procédé selon la revendication 5 ou 6, **caractérisé en ce que** l'étape de traitement comporte en outre une étape dite de confirmation dans laquelle le déclenchement est activé si les 2 conditions suivantes sont remplies : S(t) > 0.5, S(t) étant la sortie du réseau de neurones à l'instant courant et IR > Ios c'est à dire la valeur maximale du courant résiduel étant supérieure à un seuil Ios réglable.

**8.** Dispositif de détection directionnel d'un défaut terre aval pour la mise en oeuvre d'un procédé de détection selon l'une quelconque des revendications 1 à 7.

**9.** Dispositif de détection directionnel d'un défaut terre aval pour la mise en oeuvre d'un procédé de détection selon l'une quelconque des revendications 1 à 7 comportant :

- des premiers moyens (17,18) pour recevoir des signaux de courant et fournir des signaux représentatifs des courants de phase,
- des seconds moyens (19,20,21) de traitement de signal connectés aux premiers moyens précités (17,18) pour recevoir lesdits signaux représentatifs des courants de phase et pour fournir un signal de détection de défaut terre en fonction desdits signaux représentatifs des courants de phase, **caractérisé en ce que** ces moyens de traitement (19,20,21) comportent :

- des moyens de pré-traitement (19) comportant des moyens de calcul pour calculer le courant résiduel, et des moyens de comparaison (19) pour comparer la forme de ce courant résiduel avec la forme des courants de phase, et des moyens dits d'interprétation (20,21) pour interpréter cette comparaison et déduire de cette comparaison si le défaut est un défaut aval ou non de l'appareil de détection du défaut.

**10.** Dispositif selon la revendication 9, **caractérisé en ce que** les moyens (20,21) d'interprétation de cette comparaison comportent un réseau de neurones (20), les valeurs des signaux appliqués sur les entrées (e1,e2,e3,e4,e5,et e6) du réseau de neurones (20) étant représentatives de la ressemblance entre la forme des courants de phase (iaf*, ibf* et icf*) et la forme du courant résiduel (irf*).

**11.** Dispositif selon la revendication 10, **caractérisé en ce que** le réseau de neurones (20) comporte trois couches (27,28,29) de neurone n, six entrées (e1,e2,e3,e4,e5 et e6) et une sortie de signal de déclenchement SRN, les six entrées (e1,e2,e3,e4,e5 et e6) étant connectées à une première couche (27) comportant six neurones n, la sortie SRN étant connectée à une troisième couche (29) comportant un neurone, une seconde couche (28) comportant trois neurones étant connectée à la première (27) et à la troisième (29) couche.

**12.** Dispositif selon l'une quelconque des revendications 9 à11, **caractérisé en ce qu'**il comporte un filtre analogique (17) relié en entrée aux lignes de phases (a,b,c) et en sortie aux entrées d'un dispositif d'échantillonnage (18) dont les sorties sont reliées électriquement aux entrées d'un dispositif de pré-traitement (19) relié en sortie aux entrées (e1 à e6) d'un réseau de neurones (20).

**13.** Dispositif selon l'une quelconque des revendication 10 à 12, **caractérisé en ce que** le dispositif de pré-traitement (19) comporte trois entrées et six sorties, lesquelles sont reliées aux six entrées (e1,e2,e3,e4,e5 et e6) du réseau de neurones(20), lequel comporte une sortie SRN.

**14.** Dispositif selon l'une quelconque des revendications 10 à 13, **caractérisé en ce que** l'appareil de détection électrique est un relais de protection.

**15.** Dispositif selon l'une quelconque des revendications 10 à 13, **caractérisé en ce que** l'appareil de détection électrique est un indicateur de passage de défaut.

**Claims**

**1.** A method for directional detection of a load-side ground fault comprising a step consisting in providing signals representative of the phase currents, and a processing step to indicate a load-side ground fault according to said signals representative of the phase currents, **characterized in that** said processing step comprises a step of computing the residual current, a step consisting in providing a signal representative of the residual current, a comparison step consisting in comparing the form of the residual current with the form of the phase currents, and a step of interpreting this comparison enabling it to be deduced whether the fault is a fault located load-side or not of the fault detection device.

**2.** The method according to claim 1, **characterized in that** if the form of the residual current closely resembles the form of one of the phase currents, it is deduced therefrom that the fault is a load-side fault, and that if the form of the residual current does not greatly resemble the form of one of the phase currents, but only slightly resembles two of the phase currents, it is deduced therefrom that the fault is not a fault located load-side of the fault detection device.

**3.** The method according to claim 1 or 2, **characterized in that** it is implemented in a three-phase power system and **in that** if the form of the residual current does not greatly resemble the form of a single one of the phase currents, but only slightly resembles two of the phase currents, it is deduced therefrom that the fault is not a fault located load-side of the fault detection device.

**4.** The method according to any one of claims 1 to 3, **characterized in that** said step consisting in providing signals representative of the phase currents comprises a current sampling step.

**5.** The method according to claim 4, **characterized in that** the processing step comprises a pre-processing step comprising the following steps:

Te being the sampling period, nTe being the current time, N being the number of points in a period and $I_{Rn}$ being the maximum rms active current flowing in the neutral resistance.
a 1$^{st}$ step of computing the residual current:

$i_{rf}^* = i_{af}^* + i_{bf}^* + i_{cf}^*$, with $i_{af}^*$, $i_{bf}^*$, and $i_{cf}^*$ being the values of the sampled currents,
a 2$^{nd}$ step of computing the following intermediate quantities:

$$\text{mod\_}ia(nT_e) = |ia|^2_{\text{sin/cos}}$$

$$\text{mod\_}ib(nT_e) = |ib|^2_{\text{sin/cos}}$$

$$\text{mod\_}ic(nT_e) = |ic|^2_{\text{sin/cos}}$$

$$\text{mod\_}ir(nT_e) = |ir|^2_{\text{sin/cos}}$$

with $|ia|^2_{\text{sin/cos}}, |ib|^2_{\text{sin/cos}}, |ic|^2_{\text{sin/cos}}$ and $|ir|^2_{\text{sin/cos}}$ the squared moduli of the signals computed by means of a Fourier processing which extracts the fundamental component,

$$\text{mod\_}da(nT_e) = \frac{\left(|ia - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}db(nT_e) = \frac{\left(|ib - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}dc(nT_e) = \frac{\left(|ic - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))},$$

a 3$^{\text{rd}}$ step of computing the inputs of a neural network

$$e_1 = \max(\text{mod\_}da, \text{mod\_}db, \text{mod\_}dc)$$

$$e_2 = \min(\text{mod\_}da, \text{mod\_}db, \text{mod\_}dc)$$

$$e_3 = \text{mod\_}da + \text{mod\_}db + \text{mod\_}dc - e1 - e2$$

$$e_4 = \frac{\text{mod}\_ir}{2 * I_{Rn}^2}$$

$$e_5 = \left| \frac{1}{N} \sum_{k=n-N+1}^{n} \left( i_{rf}^* \left( kT_e \right) \right) \right|$$

$$e_6 = \frac{\max\left(abs\left(\text{mod}\_ia - \text{mod}\_ib, \text{mod}\_ib - \text{mod}\_ic, \text{mod}\_ic - \text{mod}\_ia\right)\right)}{\text{mod}\_ia + \text{mod}\_ib + \text{mod}\_ic}.$$

**6.** The detection method according to claim 5, **characterized in that** the processing step also comprises a 4th step of computation of the neural network (RN).

**7.** The method according to claim 5 or 6, **characterized in that** the processing step further comprises a step called confirmation step in which triggering is activated if the two following conditions are fulfilled: S(t) > 0.5, S(t) being the output of the neural network at the current time and IR > Ios, i.e. the maximum value of the residual current being higher than an adjustable threshold Ios.

**8.** A device for directional detection of a load-side ground fault for implementation of a detection method according to any one of claims 1 to 7.

**9.** A device for directional detection of a load-side ground fault for implementation of a detection method according to any one of claims 1 to 7 comprising:

 - first means (17, 18) for receiving current signals and for providing signals representative of the phase currents,
 - second signal processing means (19, 20, 21) connected to the above-mentioned first means (17, 18) to receive said signals representative of the phase currents and to provide a ground fault detection signal according to said signals representative of the phase currents, **characterized in that** these processing means (19, 20, 21) comprise:

 - pre-processing means (19) comprising means for computing the residual current, and comparison means (19) for comparing the form of this residual current with the form of the phase currents, and means called interpretation means (20, 21) for interpreting this comparison and for deducing from this comparison whether the fault is a fault located load-side or not from the fault detection device.

**10.** The device according to claim 9, **characterized in that** the means (20, 21) for interpreting this comparison comprise a neural network (20), the values of the signals applied on the inputs (e1, e2, e3, e4, e5, and e6) of the neural network (20) being representative of the resemblance between the form of the phase currents (iaf*, ibf* and icf*) and the form of the residual current (irf*).

**11.** The device according to claim 10, **characterized in that** the neural network (20) comprises three layers (27,28,29) of neurons n, six inputs (e1, e2, e3, e4, e5 and e6) and a trip signal output SRN, the six inputs (e1, e2, e3, e4, e5 and e6) being connected to a first layer (27) comprising six neurons n, the output SRN being connected to a third layer (29) comprising one neuron, a second layer (28) comprising three neurons being connected to the first layer (27) and to the third layer (29).

**12.** The device according to any one of claims 9 to11, **characterized in that** it comprises an analog filter (17) connected on input to the phase lines (a, b, c) and on output to the inputs of a sampling device (18) the outputs of which are electrically connected to the inputs of a pre-processing device (19) connected on output to the inputs (e1 to e6) of a neural network (20).

**13.** The device according to any one of claims 10 to 12, **characterized in that** the pre-processing device (19) comprises three inputs and six outputs which are connected to the six inputs (e1, e2, e3, e4, e5 and e6) of the neural network (20) which comprises an output SRN.

**14.** The device according to any one of claims 10 to 13, **characterized in that** the electric detection device is a protection relay.

**15.** The device according to any one of claims 10 to 13, **characterized in that** the electric detection device is a fault flow indicator.

**Patentansprüche**

**1.** Verfahren zur direktionalen Erkennung eines abgangsseitigen Erdschlussfehlers, das eine Stufe zur Lieferung von Phasenströme abbildenden Signalen und eine Verarbeitungsstufe zur Anzeige der Erkennung eines abgangsseitigen Erdschlussfehlers in Abhängigkeit von den genannten, Phasenströme abbildenden Signalen umfasst, **dadurch gekennzeichnet, dass** die genannte Verarbeitungsstufe eine Berechnungsstufe zur Berechnung des Differenzstroms, eine Stufe zur Lieferung eines den Differenzstrom abbildenden Signals, eine Vergleichsstufe zum Vergleich der Form des Differenzstroms mit der Form der Phasenströme sowie eine Auswertungsstufe zur Auswertung des genannten Vergleichs umfasst, die es ermöglicht abzuleiten, ob es sich bei dem Fehler um einen Fehler auf der Abgangsseite des Geräts zur Fehlererkennung handelt oder nicht.

**2.** Verfahren nach Anspruch 1, **dadurch gekennzeichnet, dass** bei starker Ähnlichkeit zwischen der Form des Differenzstroms und der Form eines der Phasenströme abgeleitet wird, dass es sich um einen abgangsseitigen Fehler handelt, und dass bei fehlender starker Ähnlichkeit zwischen der Form des Differenzstroms und der Form eines der Phasenströme abgeleitet wird, und nur leichter Ähnlichkeit zu zwei Phasenströmen abgeleitet wird, dass es sich bei dem Fehler nicht um einen Fehler auf der Abgangsseite des Geräts zur Fehlererkennung handelt.

**3.** Verfahren nach Anspruch 1 oder 2, **dadurch gekennzeichnet, dass** es in einem Dreiphasennetz eingesetzt wird und dass bei fehlender Ähnlichkeit zwischen der Form des Differenzstroms und der Form eines einzelnen Phasenstroms und nur leichter Ähnlichkeit zu zwei Phasenströmen abgeleitet wird, dass es sich bei dem Fehler nicht um einen Fehler auf der Abgangsseite des Geräts zur Fehlererkennung handelt.

**4.** Verfahren nach irgendeinem der Ansprüche 1 bis 3, **dadurch gekennzeichnet, dass** die genannte Stufe zur Lieferung von Phasenströme abbildenden Signalen eine Stufe zur Abtastung des Stroms umfasst.

**5.** Verfahren nach Anspruch 4, **dadurch gekennzeichnet, dass** die Verarbeitungsstufe eine Vorverarbeitungsstufe umfasst, die ihrerseits nachstehend aufgeführte Stufen umfasst.
Dabei entsprechen Te der Abtastperiode, nTe dem Augenblick der Stromabtastung, N der Anzahl der Abtastpunkte in einer Abtastperiode und IRn dem maximalen Effektivwert des wirksamen Stroms in einem Neutralleiterwiderstand.
Eine erste Berechnungsstufe zur Berechnung des Differenzstroms
$i_{rf}^* = i_{af}^* + i_{bf}^* + i_{cf}^*$, wobei $i_{af}^*$, $i_{bf}^*$ und $i_{cf}^*$ den Strom-Abtastwerten entsprechen;
eine zweite Berechnungsstufe zur Berechnung folgender Zwischenwerte :

$$\mathrm{mod\_}ia\,(nT_e) = \left| ia \right|^2_{\mathrm{sin/cos}}$$

$$\mathrm{mod\_}ib\,(nT_e) = \left| ib \right|^2_{\mathrm{sin/cos}}$$

$$\mathrm{mod\_}ic\,(nT_e) = \left| ic \right|^2_{\mathrm{sin/cos}}$$

$$\text{mod\_}ir(nT_e) = |ir|^2_{\text{sin/cos}} ,$$

wobei $|ia|^2_{\text{sin/cos}}$, $|ib|^2_{\text{sin/cos}}$, $|ic|^2_{\text{sin/cos}}$ und $|ir|^2_{\text{sin/cos}}$ die quadratischen Beträge der mithilfe einer Fourieranalyse berechneten Signale sind, aus der sich folgende Grundschwingung ergibt:

$$\text{mod\_}da(nT_e) = \frac{\left(|ia - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}db(nT_e) = \frac{\left(|ib - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))}$$

$$\text{mod\_}dc(nT_e) = \frac{\left(|ic - ir|^2_{\text{sin/cos}} - \min(\text{mod\_}ia(nT_e), \text{mod\_}ib(nT_e), \text{mod\_}ic(nT_e))\right)}{\max(\text{mod\_}ia(nT_e), \text{mod\_}ib(nT_e), \text{mod\_}ic(nT_e))} ,$$

eine dritte Berechnungsstufe zur Berechnung der Eingabewerte eines neuronalen Netzes:

$$e_1 = \max(\text{mod\_}da, \text{mod\_}db, \text{mod\_}dc)$$

$$e_2 = \min(\text{mod\_}da, \text{mod\_}db, \text{mod\_}dc)$$

$$e_3 = \text{mod\_}da + \text{mod\_}db + \text{mod\_}dc - e1 - e2$$

$$e_4 = \frac{\text{mod\_}ir}{2 * I^2_{Rn}}$$

$$e_5 = \left| \frac{1}{N} \sum_{k=n-N+1}^{n} \left( i^*_{rf}(kT_e) \right) \right|$$

$$e_6 = \frac{\max\left(abs(\text{mod\_}ia - \text{mod\_}ib, \text{mod\_}ib - \text{mod\_}ic, \text{mod\_}ic - \text{mod\_}ia)\right)}{\text{mod\_}ia + \text{mod\_}ib + \text{mod\_}ic}$$

6. Erkennungsverfahren nach Anspruch 5, **dadurch gekennzeichnet, dass** die Verarbeitungsstufe außerdem eine vierte Berechnungsstufe zur Berechnung des neuronalen Netzes (RN) umfasst.

**7.** Verfahren nach Anspruch 5 oder 6 , **dadurch gekennzeichnet, dass** die Verarbeitungsstufe außerdem eine so genannte Bestätigungsstufe umfasst, in der eine Abschaltung aktiviert wird, wenn die zwei folgenden Bedingungen erfüllt sind: $S(t) > 0.5$, wobei $S(t)$ = Ausgabe des neuronalen Netzes im Augenblick der Stromabtastung, und IR > Ios, d.h. der Maximalwert des Differenzstroms ist höher als ein einstellbarer Schwellwert Ios.

**8.** Einrichtung zur direktionalen Erdfehlererkennung zur Verwendung in einem Fehlererkennungsverfahren nach irgendeinem der Ansprüche 1 bis 7.

**9.** Einrichtung zur direktionalen Erkennung eines abgangsseitigen Erdschlussfehlers zur Verwendung in einem Fehlererkennungsverfahren nach irgendeinem der Ansprüche 1 bis 7, welche Einrichtung

- erste Mittel (17, 18) zur Aufnahme von Stromsignalen und Lieferung von die Phasenströme abbildenden Signalen,
- an die genannten ersten Mittel (17, 18) angeschlossene, zweite Signalverarbeitungsmittel (19, 20, 21) zur Aufnahme der genannten, die Phasenströme abbildenden Signale sowie zur Lieferung eines Erdschlussfehler-Erkennungssignals in Abhängigkeit von den genannten die Phasenströme abbildenden Signalen, **dadurch gekennzeichnet, dass** die genannten Verarbeitungsmittel (19, 20, 21) :

- Vorverarbeitungsmittel (19) mit Berechnungsmitteln zur Berechnung des Differenzstroms und Vergleichsmitteln (19) zum Vergleich der Form dieses Differenzstroms mit der Form der Phasenströme sowie so genannte Auswertungsmittel (20, 21) umfassen, die dazu dienen, den genannten Vergleich auszuwerten und daraus abzuleiten, ob es sich bei dem Fehler um einen Fehler auf der Abgangsseite des Geräts zur Erdfehlererkennung handelt oder nicht.

**10.** Einrichtung nach Anspruch 9, **dadurch gekennzeichnet, dass** die Auswertungsmittel (20, 21) zur Auswertung des Vergleichs ein neuronales Netz (20) umfassen, wobei die Werte der auf die Eingänge (e1, e2, e3, e4, e5 und e6) des neuronalen Netzes (20) gegebenen Signale die Ähnlichkeit zwischen der Form der Phasenströme (iaf*, ibf* und icf*) und der Form des Differenzstroms (irf*) abbilden.

**11.** Einrichtung nach Anspruch 10, **dadurch gekennzeichnet, dass** das neuronale Netz (20) drei Schichten (27, 28, 29) mit Neuronen n, sechs Eingänge (e1, e2, e3, e4, e5 und e6) und einen Abschaltsignal-Ausgang SRN umfasst, wobei die sechs Eingänge (e1, e2, e3, e4, e5 und e6) mit einer sechs Neuronen n umfassenden ersten Schicht (27), der Ausgang SRN mit einer, ein Neuron umfassenden dritten Schicht (29) und eine drei Neuronen umfassende zweite Schicht (28) mit der ersten Schicht (27) und der dritten Schicht (29) verbunden sind.

**12.** Einrichtung nach irgendeinem der Ansprüche 9 bis 11, **dadurch gekennzeichnet, dass** sie ein Analogfilter (17) umfasst, das eingangsseitig an die Phasenleiter (a, b, c) und ausgangsseitig an die Eingänge einer Abtastschaltung (18) angeschlossen ist, deren Ausgänge elektrisch mit den Eingängen einer Vorverarbeitungsschaltung (19) verbunden sind, die wiederum ausgangsseitig mit den Eingängen (e1 bis e6) eines neuronalen Netzes (20) verbunden ist.

**13.** Einrichtung nach einem der Ansprüche 10 bis 12, **dadurch gekennzeichnet, dass** die Vorverarbeitungsschaltung (19) drei Eingänge und sechs Ausgänge umfasst, welche mit den sechs Eingängen (e1, e2, e3, e4, e5 und e6) des neuronalen Netzes (20) verbunden sind, das einen Ausgang SRN umfasst.

**14.** Einrichtung nach irgendeinem der Ansprüche 10 bis 13, **dadurch gekennzeichnet, dass** es sich bei dem Gerät zur Fehlererkennung um ein Schutzrelais handelt.

**15.** Einrichtung nach irgendeinem der Ansprüche 10 bis 13, **dadurch gekennzeichnet, dass** es sich bei dem Fehlererkennungsgerät um einen Fehlerstromanzeiger (FPI) handelt.

**FIG. 1 (Art Antérieur)**

**FIG. 2 (Art Antérieur)**

**FIG. 3 (Art Antérieur)**

**Figure 4**

**Figure 5**

**Figure 6**

Figure 7 — Ires

Figure 8 — I1

Figure 9 — I2

Figure 10 — I3

I / A

**Figure 11**    Ires

**Figure 12**    I1

**Figure 13**    I2

**Figure 14**    I3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2004079378 A
- EP 1475874 A